**Europäisches Patentamt**

**European Patent Office**

**Office européen des brevets**

(11) Numéro de publication : **0 313 456 B1**

# (12) FASCICULE DE BREVET EUROPEEN

(45) Date de publication du fascicule du brevet :
**15.04.92 Bulletin 92/16**

(51) Int. Cl.$^5$ : **H01L 21/60, H01L 21/68**

(21) Numéro de dépôt : **88402629.5**

(22) Date de dépôt : **19.10.88**

(54) **Produit en bande pour supporter et convoyer des composants électroniques et procédé pour sa fabrication.**

(30) Priorité : **22.10.87 FR 8714629**

(43) Date de publication de la demande :
**26.04.89 Bulletin 89/17**

(45) Mention de la délivrance du brevet :
**15.04.92 Bulletin 92/16**

(84) Etats contractants désignés :
**DE GB IT SE**

(56) Documents cités :
**WO-A-84/00444**
**FR-A- 2 317 852**
**US-A- 4 466 183**
**PATENT ABSTRACTS OF JAPAN, vol. 10, no. 141 (E-406)[2198], 24 mai 1986; & JP-A-61 4262**

(73) Titulaire : **SIEMENS AKTIENGESELLSCHAFT**
**Wittelsbacherplatz 2**
**W-8000 München 2 (DE)**

(72) Inventeur : **Boucard, Michel**
**20 rue des Biches**
**F-31170 Tournefeuille (FR)**

(74) Mandataire : **de Boisse, Louis Arnaud et al**
**CABINET de BOISSE 37, Avenue Franklin D. Roosevelt**
**F-75008 Paris (FR)**

EP 0 313 456 B1

Jouve, 18, rue Saint-Denis, 75001 PARIS

## Description

La présente invention est relative à un produit en bande pour supporter, convoyer et tester des composants électroniques et à un procédé pour sa fabrication.

Plus particulièrement, l'invention concerne un tel produit relevant de la technologie de montage de composants électroniques semi-conducteurs connue sous le nom de T.A.B. (sigle de l'expression anglo-saxonne "Tape Automated Bonding").

La technologie T.A.B. est aujourd'hui très utilisée pour le montage des circuits intégrés dans des dispositifs électroniques, lorsqu'il s'agit de fabrications en grande série ou haute cadence de production ou de composants à grand nombre de sorties. Cette technologie reprend le principe de l'acheminement de pièces montées sur des bandes vers des postes de montage. Ces bandes sont réalisées de manière à fournir à la puce l'ensemble de ses connexions d'entrée/sortie, ou "pattes", avec le circuit d'accueil, les connexions étant formées dans une couche électriquement conductrice de la bande par découpe mécanique, photogravure ou autre procédé tel que le procédé de découpe au laser décrit dans la demande de brevet européen N° 130.498.

On connaît notamment une variante de la technologie T.A.B., dite "simple couche", dans laquelle une bande métallique unique fournit à la fois le support nécessaire au convoyage des puces et les connexions d'entrée/sortie de chaque puce. Ces connexions étant solidaires de la bande, il convient de séparer celles-ci de cette bande avant de procéder au pliage des "pattes" et à l'installation de la puce sur le circuit d'accueil. On remarquera qu'avant cette séparation, toutes les connexions ou "pattes" de la puce sont court-circuitées du fait de leurs liaisons à la bande métallique. Dans ces conditions, il n'est pas possible de procéder à des tests de la puce avant que celle-ci ne soit détachée de la bande. Il serait pourtant très commode de procéder à ces tests alors que les puces sont solidaires de la bande.

On connaît un procédé qui consiste à surmouler la puce ainsi que deux sorties de test isolées électriquement, pour maintenir la puce sur la bande conductrice. On peut alors fairer passer la puce dans un appareil de test assurant le maintien des sorties de la puce, appareil de test qui n'est donc pas standard.

On décrit au brevet des Etats-Unis d'Amérique N° 4.480.150 et à la demande anglaise N° 2.169.553 des structures de bandes transporteuses autorisant des tests sur les puces portées par la bande. Notamment, la demande anglaise précitée concerne une telle structure en technologie T.A.B. Cependant la structure proposée est du type "T.A.B. trois-couches" et n'est pas transposable à une bande du type "T.A.B. simple couche".

Or, cette dernière structure s'avère intéressante, et même indispensable, dans certaines applications telles que le montage T.A.B. de puces de puissance qui implique la circulation de courants relativement forts dans certaines connexions. L'épaisseur importante de la bande conductrice (couramment 70µm ou l05µm en T.A.B. simple couche) autorise le passage de tels courants, plus forts que ceux supportables en technologie T.A.B. à deux ou trois couches.

La présente invention a donc pour but de réaliser un produit en bande, du type de ceux utilisés en technologie T.A.B. simple couche, et conçu pour autoriser des tests des puces montées sur le produit alors que ces puces sont solidaires du produit, dans des appareils de test standards.

La présente invention a aussi pour but de réaliser un tel produit en bande plus particulièrement destiné au montage de puces de puissance.

La présente invention a encore pour but de fournir un procédé de fabrication de ce produit en bande.

On atteint ces buts de l'invention, ainsi que d'autres qui apparaîtront dans la suite, avec un produit en bande pour supporter et convoyer des composants électroniques échelonnés sur le produit, comprenant une bande en matériau conducteur de l'électricité découpée d'une série échelonnée de fenêtres, des pattes de connexion électrique découpées dans la bande à l'intérieur de chaque fenêtre à partir du contour de celle-ci, ces pattes étant associées chacune à une des sorties d'un composant électronique, caractérisé en ce qu'il comprend une pièce adhésive électriquement isolante appliquée sur la face de la bande conductrice qui ne reçoit pas les composants de manière à adhérer à celle-ci et aux pattes de connexion au moins au voisinage du contour de la fenêtre, intérieurement et extérieurement à celui-ci, au moins un jour traversant le produit pour assurer l'isolation électrique d'au moins une patte sans supprimer sa liaison à la pièce adhésive.

L'invention fournit aussi un procédé de fabrication du produit défini ci-dessus, suivant lequel on forme dans une bande en matériau conducteur de l'électricité des fenêtres échelonnées sur la bande et présentant un ensemble de pattes de connexion électrique découpées dans la bande à l'intérieur de chaque fenêtre à partir du contour de celle-ci, pour être associées chacune à une sortie d'un composant électronique à monter sur ces pattes, ce procédé étant caractérisé en ce qu'on contrecolle une pièce adhésive électriquement isolante contre la face de la bande conductrice qui n'est pas destinée à recevoir les composants, de manière que cette pièce adhésive couvre au moins le contour de la fenêtre et des zones intérieurement et extérieurement adjacentes à celui-ci, et on perce au moins un jour à travers le produit, agencé de manière à assurer l'isolation électrique d'au moins une patte de connexion vis-à-vis de la bande conductrice, sans supprimer la liaison de cette patte et de la pièce adhésive.

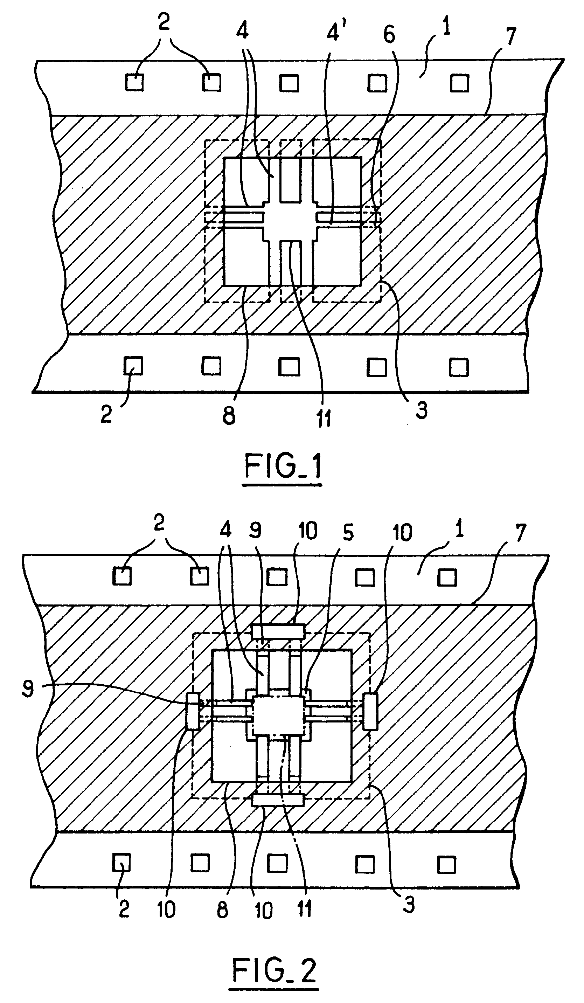

Au dessin annexé, les figures 1 et 2 représentent des vues en plan d'une partie du produit en bande suivant l'invention, à deux étapes successives de sa fabrication.

Ce produit (voir figure 1) est essentiellement constitué d'une bande (1) en matériau conducteur de l'électricité, percée latéralement de deux rangées de perforations (2) utiles à l'entraînement et à l'indexation de la bande, comme il est bien connu dans la technique. La bande est, en outre, percée de fenêtres (3) régulièrement échelonnées. Du bord d'une fenêtre (3) rayonnent intérieurement des pattes de connexion électrique telles que (4) ou (4'), découpées dans le matériau conducteur de la bande (1) pour établir une connexion entre les entrées/sorties d'un composant électronique telle qu'une "puce" constituant un circuit intégré, et un dispositif électronique dont ce circuit intégré constitue un élément. Les pattes sont découpées dans la bande en même temps que la fenêtre et sont donc alors solidaires de la bande (1) par leurs bases au niveau du contour de la fenêtre (3), comme représenté en (6) à la figure 1 pour la patte (4'). Les extrémités des pattes qui sont opposées aux bases sont en outre solidarisées par une partie centrale (11) découpée dans la fenêtre (3) en même temps que les pattes.

Après enlèvement de cette partie centrale (11), on peut monter une puce sur les extrémités des pattes. La connexion puce/patte est réalisée par soudure d'un plot de contact prévu sur la puce, sur l'extrémité libre d'une patte associée à ce plot. A ce point de la description, la bande (1) est tout-à-fait conforme à une bande T.A.B. simple face connue dans la technique (voir par exemple la bande représentée à la Fig.2 de la demande européenne N° 130.498 précitée). De telles bandes, après montage de la puce sur les pattes, ne permettent pas d'appliquer des signaux de test à ces pattes du fait que les bases (6) de ces pattes sont mises en court-circuit par la bande conductrice (1) elle-même. Il n'est pas possible de vérifier le bon fonctionnement de la puce avant que celle-ci ne soit détachée, avec ses pattes de connexion, de la bande. Il faut alors réorienter la puce dans un poste de test ce qui implique du temps et des manoeuvres, et donc des coûts supplémentaires.

Suivant la présente invention, on perfectionne la bande décrite ci-dessus en lui ajoutant des moyens propres à isoler électriquement les pattes de connexion tout en conservant la fonction de support et de convoyage de la puce par la bande.

A cette fin, le produit en bande suivant l'invention comprend en outre une pièce adhésive telle qu'une bande adhésive (7) collée, par exemple, sur la face du produit qui est opposée à celle qui porte la puce. Suivant un mode de réalisation préféré de l'invention, la bande adhésive (7) est de largeur inférieure à celle de la bande conductrice (1), de manière à ne pas recouvrir les rangées de perforations. La bande adhésive (7) est percée de fenêtres (8) régulièrement échelonnées avec le même pas que les fenêtres (3) de la bande conductrice (1). Lors du contrecollage des bandes (1) et (7), des moyens sont prévus pour assurer la mise en repérage des fenêtres (3) et (8), de manière à assurer leur concentricité. Suivant le mode de réalisation représenté à la figure 1, les deux fenêtres sont rectangulaires et la fenêtre (8) présente un contour parallèle et intérieur à celui de la fenêtre (3). Ainsi il apparaît que la base (6) de chaque patte de connexion est recouverte par la bande adhésive (7). Ce recouvrement a pour but d'assurer, dans une étape ultérieure de l'évolution du produit, le support des pattes et de la puce par la bande adhésive, comme on le verra dans la suite en liaison avec l'examen de la figure 2. La fenêtre (8) de la bande adhésive dégage cependant la puce et la plus grande partie des pattes pour ne pas interférer avec celles-ci lorsqu'elles seront détachées du produit suivant l'invention, au poste où s'opère l'insertion de la puce dans le circuit électronique dont elle constitue un composant.

La pièce adhésive peut être formée d'un support recouvert d'une couche adhésive ou d'un film "non supporté" constitué par un film d'un produit adhésif polymérisable et partiellement polymérisé sur une face pour lui donner une tenue mécanique suffisante. Suivant une autre variante, la pièce adhésive peut être réalisée par surmoulage d'un produit adhésif autour de la fenêtre (3), surmoulage obtenu par sérigraphie par exemple.

Tel que décrit jusqu'à présent, le produit suivant l'invention ne permet toujours pas de tester la puce.

On atteint ce but de l'invention en perçant (voir figure 2, qui représente le produit suivant l'invention dans son état final) des jours (10) qui traversent les deux bandes (1) et (7), au voisinage des bases (6) d'au moins certaines des pattes (4, 4') de manière à supprimer à cet endroit toute liaison électrique entre ces pattes lorsque celles-ci sont conçues pour transmettre des signaux de test à une puce (5) ou lorsque l'isolation d'une patte particulière est nécessaire à la réalisation des tests. Dans la mesure où certaines pattes peuvent rester court-circuitées sans perturber les tests, ou bien si ce court-circuit est nécessaire à l'exécution des tests, aucun jour n'est percé à la base des pattes correspondantes. En principe, cependant, l'isolation électrique de toutes les pattes, comme représenté à la figure, est nécessaire.

On remarquera que les jours (10) sont placés à cheval sur le contour de la fenêtre (3) avec une garde vis-à-vis du contour de la fenêtre (8) qui ménage sur la bande adhésive une place suffisante pour les parties (9) des pattes, de manière à maintenir solidement par adhésion ces pattes sur le produit en bande suivant l'invention, ceci en dépit du fait que les bases (6) de ces pattes sont alors physiquement désolidarisées de la bande conductrice (1), par le percement des jours (10) dans le produit.

La puce (5) étant alors montée sur les pattes (4) ainsi fixées sur le produit en bande suivant l'invention, il est possible de convoyer successivement les puces portées par ce produit en bande jusqu'à un poste de test ou des électrodes prévues dans le poste sont sélectivement mises en contact avec des pattes de connexion isolées électriquement, pour appliquer à la puce des signaux de test et prélever des signaux de sortie permettant d'analyser les résultats du test.

La présente invention concerne aussi un procédé de fabrication du produit en bande suivant l'invention. Ce procédé consiste d'abord à former dans une bande conductrice de l'électricité (par exemple une bande de cuivre de 70μm ou 105μm d'épaisseur, dans l'une quelconque des largeurs standard : 8, 16, 35 ou 70 mm) des fenêtres (3) échelonnées, du contour desquelles débordent intérieurement des pattes de connexion électrique. On peut utiliser à cet effet diverses techniques connues de découpe mécanique ou au laser, ou de photogravure, comme on l'a mentionné plus haut. Suivant l'invention on contrecolle ensuite sur la bande conductrice ainsi formée une bande adhésive électriquement isolante et percée de fenêtres (8), échelonnées régulièrement avec le même pas que les fenêtres de la bande conductrice. La bande adhésive est plaquée sur la face de la bande conductrice qui est opposée à celle qui reçoit les puces. Le placage de la bande adhésive peut s'opérer par laminage ou report et pressage, à froid ou à chaud dans les deux cas, suivant des techniques connues. On utilise des moyens de mise en repérage connus pour assurer le centrage des fenêtres (8) de la bande adhésive sur les fenêtres (3) de la bande conductrice, ces dernières présentant des dimensions supérieures à celles des fenêtres (8), comme on l'a vu plus haut.

On soude ensuite les puces (5) sur le produit intermédiaire ainsi constitué et on poinçonne les jours d'isolation (10) des pattes.

Suivant une variante, ces deux dernières opérations sont interverties. Dans ce cas il convient d'assurer le maintien des extrémités des pattes opposées aux bases (6), avant l'opération de poinçonnage, en conservant à ce niveau une liaison entre les pattes par la partie (11) de la bande conductrice, délimitée à la figure en trait mixte. Au moment du poinçonnage, cette partie (11) est enlevée en même temps que la matière intérieure aux contours des jours (10).

Comme représenté à la figure, un jour (10) peut englober les bases (6) de deux pattes adjacentes. Il est clair que le nombre de bases (6) englobées par un jour peut varier en fonction des besoins. On adoptera néanmoins une distribution de jours autour de la fenêtre (3) qui ne porte pas atteinte à la cohésion des deux bandes (1) et (7), notamment dans la partie qui se trouve entre les fenêtres (3) et (8). Il s'agit là de dispositions qui sont laissées à l'initiative de l'homme de métier.

La bande adhésive pourrait être remplacée par des cadres adhésifs fixés en repérage sur les fenêtres (3) de manière à déborder à l'intérieur de ces fenêtres pour y supporter les extrémités des pattes de connexion. De même, les jours d'isolement (10) peuvent prendre d'autres formes et/ou d'autres positions, dans la mesure où ils assurent cependant une isolation électrique efficace des pattes de connexion tout en permettant le support des pattes isolées par la bande ou le cadre adhésif.

Ainsi, grâce à l'invention, on dispose d'un produit en bande dont la partie conductrice de l'électricité peut-être réalisée par la technique T.A.B. "simple face" et qui autorise le test des puces par passage du produit dans un poste de test standard. Après le test, le produit en bande peut être utilisé pour convoyer les puces dans une poste de pliage des pattes ou de montage, où les pattes sont coupées à l' intérieur de la fenêtre (8). Il ne demeure ainsi aucune trace d'adhésif sur ces pattes. En outre la réalisation du produit suivant l'invention à partir d'une simple bande d'un matériau conducteur de l'électricité permet de graver cette bande par les deux faces à la fois ou même de la poinçonner. On peut alors utiliser une bande conductrice d'une épaisseur compatible avec les courants traités dans les circuits intégrés de puissance.

## Revendications

1. Produit en bande pour supporter et convoyer des composants électroniques échelonnés sur le produit, comprenant une bande (1) en matériau conducteur de l'électricité découpée d'une série échelonnée de fenêtres (3), des pattes de connexion électriques (4,4') découpées dans la bande à l'intérieur de chaque fenêtre (3) à partir du contour de celle-ci, ces pattes (4,4') étant associées chacune à une des sorties d'un composant électronique, caractérisé en ce qu'il comprend une pièce adhésive électriquement isolante (7) appliquée sur la face de la bande conductrice (1) qui ne reçoit pas les composants de manière à adhérer à celle-ci et aux pattes de connexion (4,4') au moins au voisinage du contour de la fenêtre, intérieurement et extérieurement à celui-ci, au moins un jour (10) traversant le produit pour assurer l'isolation électrique d'au moins une patte (4,4') sans supprimer sa liaison à la pièce adhésive (1).

2. Produit conforme à la revendication 1, caractérisé en ce que la pièce adhésive est une bande adhésive (7) découpée d'une suite de fenêtres (8) échelonnées avec le même pas que celles de la bande conductrice (1), le contour d'une fenêtre (8) de la bande adhésive étant intérieur au contour de la fenêtre (3) associée de la bande conductrice (1).

3. Produit conforme à la revendication 2, caractérisé en ce que le contour d'une fenêtre (8) de la bande adhésive est parallèle au contour de la fenêtre (3) associée de la bande conductrice.

4. Produit conforme à l'une quelconque des revendications 2 et 3, caractérisé en ce que les contours de deux fenêtres (3) et (8) associées sont concentriques et rectangulaires.

5. Produit conforme à la revendication 1, caractérisé en ce que la pièce adhésive est un cadre adhésif associé à chaque fenêtre (3) de la bande conductrice et fixé sur celle-ci de manière à déborder intérieurement et extérieurement du contour de la fenêtre (3) associée.

6. Produit conforme à l'une quelconque des revendications précédentes, caractérisé en ce que le contour du jour (10) d'isolation est écarté du contour de la fenêtre (8) de la pièce adhésive, de manière qu'une partie (9) de la patte de connexion associé soit collée à cette bande entre ces deux contours.

7. Produit conforme à l'une quelconque des revendications précédentes, caractérisé en ce que le contour du jour (10) est placé à cheval sur le contour de la fenêtre (3) formée dans la bande conductrice.

8. Produit conforme à l'une quelconque des revendications 1 à 7, caractérisé en ce qu'il comprend plusieurs jours percés de manière à isoler chacune de plusieurs pattes les unes des autres et par rapport à la bande conductrice.

9. Produit conforme à la revendication 1, caractérisé en ce que la pièce adhésive est constituée d'un film de produit adhésif non supporté.

10. Produit conforme à la revendication 1, caractérisé en ce que la pièce adhésive est formée autour de la fenêtre (3) de la bande conductrice par surmoulage d'un produit adhésif intérieurement et extérieurement au contour de ladite fenêtre.

11. Produit conforme à l'une quelconque des revendications précédentes, caractérisé en ce que le composant électronique est un circuit intégré sous forme de "puce".

12. Procédé de fabrication du produit conforme à l'une quelconque des revendications 1 à 11, suivant lequel a) on forme dans une bande (1) en matériau conducteur de l'électricité des fenêtres (3) échelonnées sur la bande et présentant un ensemble de pattes (4,4′) de connexion électrique découpées dans la bande à l'intérieur de chaque fenêtre (3) à partir du contour de celle-ci, pour être associées chacune à une sortie d'un composant électronique, ce procédé étant caractérisé en ce que b) on contrecolle une pièce adhésive (7) électriquement isolante contre la face de la bande conductrice (1) qui n'est pas destinée à recevoir les composants, de manière que cette pièce adhésive couvre au moins le contour de la fenêtre et des zones intérieurement et extérieurement adjacentes à celle-ci, et c) on perce au moins un jour (10) à travers le produit, agencé de manière à assurer l'isolation électrique d'au moins une patte (4,4′) de connexion vis-à-vis de la bande conductrice (1) sans supprimer la liaison de cette patte et de la pièce adhésive.

13. Procédé conforme à la revendication 12, caractérisé en ce qu'on utilise une pièce adhésive (7) en forme de bande découpée de fenêtres (8) échelonnées avec le même pas que celui des fenêtres (3) de la bande conductrice, mais de dimensions plus petites, et on contrecolle en repérage la bande adhésive ainsi découpée de fenêtres contre la bande conductrice, de manière que les contours des fenêtres de la bande adhésive soient intérieurs à ceux des fenêtres associées de la bande conductrice.

14. Procédé conforme à la revendication 13, caractérisé en ce que, pour la découpe du jour d'isolation (10) d'une patte de connexion, on perce le produit suivant un contour qui est écarté du contour de la fenêtre associée de la bande adhésive.

15. Procédé conforme à l'une quelconque des revendications 13 et 14, caractérisé en ce qu'on soude les plots de sortie du composant électrique sur des extrémités des pattes de connexion avant le perçage du jour d'isolation.

16. Procédé conforme à l'une quelconque des revendications 13 et 14, caractérisé en ce qu'on soude les plots de sortie du composant électrique sur des extrémités des pattes de connexion après le perçage des jours d'isolation.

17. Procédé conforme à la revendication 12, caractérisé en ce que, pour le contrecollage de la pièce adhésive, on surmoule un produit adhésif intérieurement et extérieurement au contour de la fenêtre (3)

18. Procédé conforme à l'une quelconque des revendications 12 à 17, caractérisé en ce qu'on applique des signaux de test aux composants portés par le produit en bande, par au moins une des pattes isolées par un jour de la bande conductrice.

**Patentansprüche**

1. Produkt in Bandform zum Abstützen und Transportieren elektronischer Bauelemente, die auf dem Produkt gestaffelt angeordnet sind, mit einem Trägerband (1) aus elektrisch leitendem Material, in das eine Reihe beabstandeter Fenster (3) eingeschnitten ist, und mit elektrischen Anschlußteilen (4,4′), die im Inneren jedes Fensters (3) ausgehend von dessen Umriß in das Band eingeschnitten sind, wobei diese Anschlußteile (4,4′) jeweils einem der Ausgänge eines elektronischen Bauelementes zugeordnet sind, dadurch gekennzeichnet, daß es ein elektrisch isolierendes Klebeteil (7) aufweist, das auf der von den Bauelementen abgewandten Seite des Leiterbandes (1) so aufgebracht ist, daß es an diesem sowie an den Verbindungsteilen (4,) angrenzend am Umriß des Fensters, und zwar sowohl innerhalb wie auch außerhalb des Fensters, haftet, wobei mindestens ein Schlitz (10) in dem Produkt vorgesehen ist, um mindestens ein Anschlußteil (4,4') elektrisch zu isolieren, ohne seine Verbindung mit dem Klebeteil (1) zu unterbrechen.

2. Produkt nach Anspruch 1, dadurch gekennzeichnet, daß das Klebeteil als Klebeband (7) ausgebildet ist, in das eine Folge von beabstandeten Fenstern (8) mit derselben Teilung wie die Fenster des Leiterbandes (1) eingeschnitten ist, wobei sich der Umriß eines Fensters (8) des Klebebandes innerhalb des Umrisses des zugehörigen Fensters (3) des Leiterbandes (1) befindet.

3. Produkt nach Anspruch 2, dadurch gekennzeichnet, daß der Umriß eines Fensters (8) des Klebebandes parallel zum Umriß des zugehörigen Fensters (3) des Leiterbandes verläuft.

4. Produkt nach Anspruch 2 oder 3, dadurch gekennzeichnet, daß die Umrisse der beiden einander zugeordneten Fenster (3,8) konzentrisch zueinander und rechteckig ausgebildet sind.

5. Produkt nach Anspruch 1, dadurch gekennzeichnet, daß das Klebeteil als Kleberahmen ausgebildet ist, der jedem Fenster (3) des Leiterbandes zugeordnet und an diesem so befestigt ist, daß er innen und außen über den Umriß des zugehörigen Fensters (3) übersteht.

6. Produkt nach einem der vorhergehenden Ansprüche, dadurch gekennzeichnet, daß der Umriß des isolierenden Schlitzes (10) zu dem Umriß des Fensters (8) des Klebestreifens so beabstandet ist, daß ein Abschnitt (9) des zugehörigen Anschlußteiles mit dem Klebeband zwischen diesen beiden Umrissen verklebt ist.

7. Produkt nach einem der vorhergehenden Ansprüche, dadurch gekennzeichnet, daß der Umriß des Schlitzes (10) den Umriß des im Leiterband gebildeten Fensters (3) überlappt.

8. Produkt nach einem der Ansprüche 1 bis 7, dadurch gekennzeichnet, daß es mehrere Schlitze aufweist, die so angeordnet sind, daß sie jedes Anschlußteil von mehreren Anschlußteilen untereinander sowie bezüglich des Leiterbandes isolieren.

9. Produkt nach Anspruch 1, dadurch gekennzeichnet, daß das Klebeteil von einem Film aus einem trägerfreien Klebstoff gebildet wird.

10. Produkt nach Anspruch 1, dadurch gekennzeichnet, daß das Klebeteil um das Fenster (3) des Leiterbandes herum verlaufend dadurch gebildet ist, daß ein Klebstoff innen und außen um den Umriß des Fensters herum gegossen wird.

11. Produkt nach einem der vorhergehenden Ansprüche, dadurch gekennzeichnet, daß die elektronische Komponente ein integrierter Schaltkreis in Form eines "Chips" ist.

12. Verfahren zum Herstellen eines Produktes nach einem der Ansprüche 1 bis 11, bei dem a) in einem Leiterband (1) aus elektrisch leitendem Material Fenster (3) eingeschnitten werden, die längs des Bandes gestaffelt angeordnet sind und eine Anordnung von elektrischen Anschlußteilen (4,4') aufweisen, die im Inneren jedes Fensters (3) ausgehend vom Umriß desselben in das Band eingeschnitten sind, um jeweils einem Ausgang eines elektronischen Bauelementes zugeordnet zu werden, wobei dieses Verfahren dadurch gekennzeichnet ist, daß b) ein elektrisch isolierendes Klebeteil (7) gegen diejenige Seite des Leiterbandes (1) geklebt wird, die nicht zur Aufnahme der Komponenten bestimmt ist, derart, daß das Klebeteil mindestens den Umriß des Fensters und die innen wie außen angrenzenden Bereiche desselben bedeckt, und c) mindestens ein Schlitz (10) in dem Produkt gebildet wird, derart, daß mindestens ein Anschlußteil (4,4') gegenüber dem Leiterband (1) elektrisch isoliert wird, ohne seine Verbindung mit dem Klebeteil zu unterbrechen.

13. Verfahren nach Anspruch 12, dadurch gekennzeichnet, daß als Klebeteil (7) ein Klebeband verwendet wird, in das Fenster (8) mit der gleichen Teilung wie derjenigen der Fenster (3) des Leiterbandes, jedoch mit kleineren Abmessungen eingeschnitten sind, und daß das auf diese Weise mit Fenstern versehene Klebeband registerhaltig auf das Leiterband geklebt wird, derart, daß sich die Umrisse der Fenster des Klebebandes innerhalb derjenigen der zugehörigen Fenster des Leiterbandes befinden.

14. Verfahren nach Anspruch 13, dadurch gekennzeichnet, daß zum Einschneiden eines Schlitzes (10) zum Isolieren eines Anschlußteiles das Produkt längs einer Kontur durchschnitten wird, die von dem Umriß des zugehörigen Fensters des Klebebandes beabstandet ist.

15. Verfahren nach Anspruch 13 oder 14, dadurch gekennzeichnet, daß Ausgangskontakte des elektrischen Bauelementes an den Enden der Anschlußteile angeschweißt werden, ehe der isolierende Schlitz eingeschnitten wird.

16. Verfahren nach Anspruch 13 oder 14, dadurch gekennzeichnet, daß Ausgangskontakte des elektrischen Bauelementes an den Enden der Anschlußteile angeschweißt werden, nachdem die isolierenden Schlitze eingeschnitten wurden.

17. Verfahren nach Anspruch 12, dadurch gekennzeichnet, daß zum Verkleben des Klebeteiles ein Klebstoff innen und außen auf den Umriß des Fensters (3) gegossen wird.

18. Verfahren nach einem der Ansprüche 12 bis 17, dadurch gekennzeichnet, daß Prüfsignale durch mindestens eines der Anschlußteile, die durch einen Schlitz des Leiterbandes isoliert sind, auf von dem bandförmigen Produkt getragenen Bauelemente aufgebracht werden.

## Claims

1. Product in tape form for supporting and conveying electronic components staggered on the product, comprising a tape (1) made of electrically conductive material and cut with a staggered series of windows (3), and electrical connection tabs (4, 4') cut out from the tape within each window (3), starting from the contour of the latter, these tabs (4,4') each being associated with one of the outputs of an electronic component, characterised in that it comprises an electrically insulating adhesive piece (7) applied to that face of the conductive tape (1) not receiving the components, so as to adhere to this and to the connection tabs (4,4') at least in the vicinity of the contour of the window, within and on the outside of this, at least one aperture (10) passing through the product in order to ensure the electrical insulation of at least one tab (4, 4') without breaking its connection with the adhesive piece (1) [sic].

2. Product according to Claim 1, characterised in that the adhesive piece is an adhesive tape (7) cut with a succession of windows (8) staggered at the same interval as those of the conductive tape (1), the contour of a window (8) of the adhesive tape being within the contour of the associated window (3) of the conductive tape (1).

3. Product according to Claim 2, characterised in that the contour of a window (8) of the adhesive tape is parallel to the contour of the associated window (3) of the conductive tape.

4. Product according to either of Claims 2 and 3, characterised in that the contours of two associated windows (3) and (8) are concentric and rectangular.

5. Product according to Claim 1, characterised in that the adhesive piece is an adhesive frame associated with each window (3) of the conductive tape and fastened to the latter so as to project from the contour of the associated window (3) on the inside and on the outside.

6. Product according to any of the preceding claims, characterised in that the contour of the insulating aperture (10) is set apart from the contour of the window (8) of the adhesive piece, in such a way that a part (9) of the associated connection tab is bonded to this tape between these two contours.

7. Product according to any of the preceding claims, characterised in that the contour of the aperture (10) is placed astride the contour of the window (3) formed in the conductive tape.

8. Product according to any of Claims 1 to 7, characterised in that it possesses several apertures pierced in such a way as to insulate each of several tabs from one another and from the conductive tape.

9. Product according to Claim 1, characterised in that the adhesive piece is composed of an unsupported film of adhesive product.

10. Product according to Claim 1, characterised in that the adhesive piece is formed round the window (3) of the conductive tape by moulding on an adhesive product within and on the outside of the contour of the said window.

11. Product according to any of the preceding claims characterised in that the electronic component is an integrated circuit in the form of a "chip".

12. Process for producing the product according to any of Claims 1 to 11, according to which a) there are formed in a tape (1) made of electrically conductive material windows (3) staggered on the tape and having a set of electrical connection tabs (4, 4') cut out from the tape within each window (3), starting from the contour of the latter, so as to each be associated with an output of an electronic component, this process being characterised in that b) an electrically insulating adhesive piece (7) is glued against that face of the conductive tape (1) not intended for receiving the components, in such a way that this adhesive piece covers at least the contour of the window and zones internally and externally adjacent to this, and c) at least one aperture (10) is pierced through the product and is arranged so as to ensure the electrical insulation of at least one connection tab (4, 4') relative to the conductive tape (1), without breaking the connection between this tab and the adhesive piece.

13. Process according to Claim 12, characterised in that an adhesive piece (7) in tape form cut with windows (3) staggered at the same interval as that of the windows (3) of the conductive tape, but of smaller dimensions, is used, and the adhesive tape thus cut with windows is glued against the conductive tape with location-fixing, in such a way that the contours of the windows of the adhesive tape are within those of the associated windows of the conductive tape.

14. Process according to Claim 13, characterised in that, for cutting out the aperture (10) for insulating a connection tab, the product is pierced along a contour which is set apart from the contour of the associated window of the adhesive tape.

15. Process according to either of Claims 13 and 14, characterised in that the output studs of the electrical component are welded to ends of the connection tabs before the piercing of the insulating aperture.

16. Process according to either of Claims 13 and 14, characterised in that the output studs of the electrical component are welded to ends of the connection tabs after the piercing of the insulating apertures.

17. Process according to Claim 12, characterised in that for the gluing of the adhesive piece, an adhesive product is moulded on within and on the outside of the contour of the window (3).

18. Process according to any of Claims 12 to 17, characterised in that test signals are applied to the components carried by the product in tape form, via at least one of the tabs insulated by means of an aperture of the conductive tape.

FIG_1

FIG_2